# EUROPEAN PATENT APPLICATION

(11) **EP 4 322 105 A1**
(43) Date of publication of application: **14.02.2024**
(21) Application number: 21935966.8
(22) Date of filing: 06.04.2021
(51) Int. Cl.: G06T 7/00, H05K 13/08

(54) **STORAGE DEVICE AND METHOD FOR UPDATING IMAGE DETERMINATION PROCESS STORED IN STORAGE DEVICE**

(71) Applicant: Fuji Corporation, Chiryu-shi, Aichi 472-8686 (JP)
(72) Inventor: ISHIKAWA, Kazuma, Chiryu-shi, Aichi 472-8686 (JP)
(74) Representative: Grünecker Patent- und Rechtsanwälte PartG mbB
(86) International application number: PCT/JP2021/014611
(87) International publication number: WO 2022/215161

(57) **Abstract**

A storage device stores master data of one type of component and an image determination process for determining whether one component among multiple scattered components of one type overlaps another component based on an image obtained by imaging the one component, in which in a case where the master data is updated, the image determination process is also updated.

## Description

### Technical Field

The present invention relates to a storage device and the like for storing master data of one type of component and an image determination process for determining whether one component among multiple scattered components of one type overlaps another component based on an image obtained by imaging one component.

### Background Art

As described in the following patent literature, some storage devices store data indicating a posture of a component and data for determining whether the component overlaps another component.

### Patent Literature

Patent Literature 1: JP 2016-219432A

### Summary of the Invention

### Technical Problem

It is an object of the present invention to appropriately execute an image determination process for determining whether a component overlaps another component.

### Solution to Problem

In order to solve the above problem, the present description discloses a storage device that stores master data of one type of component and an image determination process for determining whether one component among multiple scattered components of one type overlaps another component based on an image obtained by imaging the one component, in which in a case where the master data is updated, the image determination process is also updated.

In order to solve the above problem, the present description discloses a method for updating an image determination process in a storage device in which master data corresponding to a posture when components of one type are scattered and an image determination process for determining whether one component among multiple scattered components of one type overlaps another component are stored, the method including a storage date and time comparison step of comparing a date and time at which the master data in the storage device is stored with a date and time at which the image determination process is stored; an update step of updating the image determination process stored in the storage device by using the master data in a case where the date and time at which the master data is stored in the storage date and time comparison step is new; and an overwriting step of erasing the image determination process stored in the storage device and causing the storage device to store the image determination process updated in the update step.

### Advantageous Effect of the Invention

According to the present disclosure, in a case where the master data is updated, the image determination process is also updated. Alternatively, in a case where the stored date and time of the master data is later than the stored date and time of the image determination process, the image determination process is updated. As a result, it is possible to appropriately update the image determination process and thus to appropriately execute the image determination process.

### Brief Description of Drawings

Fig. 1 is a perspective view illustrating a component mounter.
Fig. 2 is a perspective view illustrating a component mounting device of the component mounter.
Fig. 3 is a perspective view illustrating a bulk component supply device.
Fig. 4 is a perspective view illustrating a component supply unit.
Fig. 5 is a transparent view illustrating the component supply unit.
Fig. 6 is a transparent view illustrating the component supply unit.
Fig. 7 is a perspective view illustrating a component scattering device.
Fig. 8 is a perspective view illustrating the component scattering device.
Fig. 9 is a perspective view illustrating a component holding head.
Fig. 10 is a diagram illustrating a component receiving member in a state in which an electronic circuit component is housed.
Fig. 11 is a block diagram illustrating a control device for the component mounter.
Fig. 12 is a diagram illustrating a state in which lead components are scattered on a stage.
Fig. 13 is a diagram illustrating pattern matching data.
Fig. 14 is a diagram illustrating overlap determination data.
Fig. 15 is a conceptual diagram when an overlap determination process is executed.
Fig. 16 is a diagram illustrating a first creation screen.
Fig. 17 is a diagram illustrating a second creation screen.
Fig. 18 is a diagram illustrating pattern matching data.
Fig. 19 is a diagram illustrating overlap determination data.

### Description of Embodiments

Hereinafter, as exemplary embodiments of the present invention, examples of the present invention will be described in detail with reference to drawings.

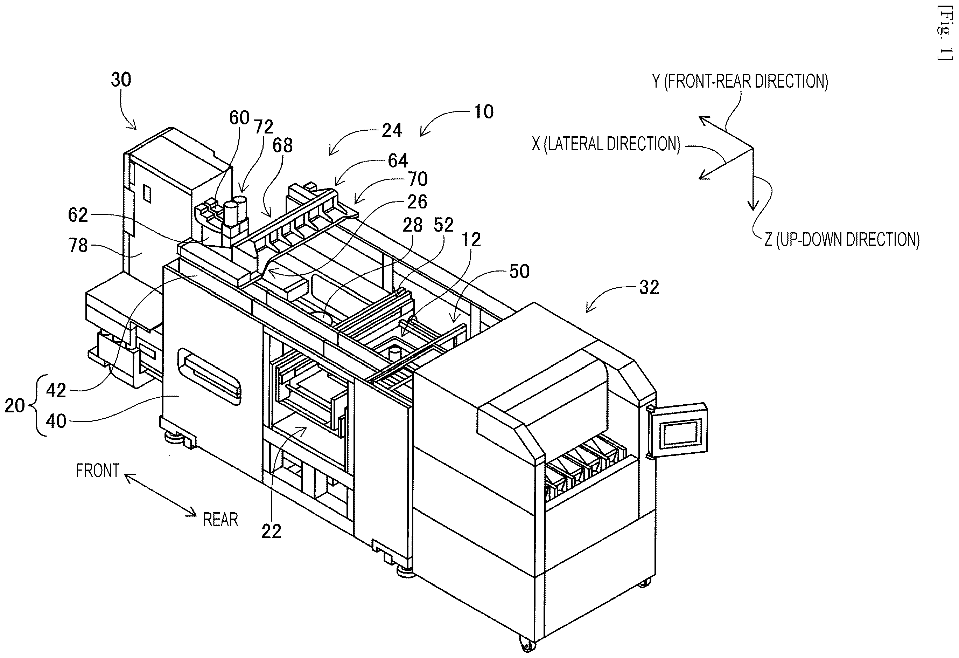

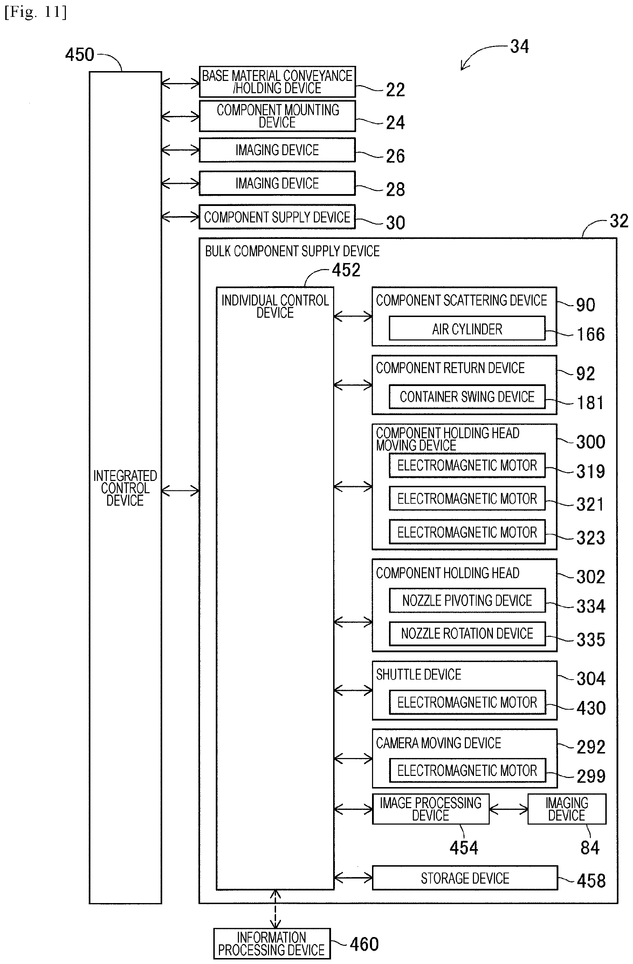

Fig. 1 illustrates component mounter 10. Component mounter 10 is a device that executes mounting work of a component on circuit base material 12. Component mounter 10 includes device main body 20, base material conveyance/holding device 22, component mounting device 24, imaging devices 26 and 28, component supply device 30, bulk component supply device 32, and control device (refer to Fig. 11) 34. A circuit board, a base material having a three-dimensional structure, and the like are raised as circuit base material 12, and a printed wiring board, a printed circuit board, and the like are raised as a circuit board.

Device main body 20 includes frame 40 and beam 42 suspended on frame 40. Base material conveyance/holding device 22 is disposed at the center of frame 40 in a front-rear direction, and has conveyance device 50 and clamp device 52. Conveyance device 50 is a device that conveys circuit base material 12, and clamp device 52 is a device that holds circuit base material 12. As a result, base material conveyance/holding device 22 conveys circuit base material 12 and fixedly holds circuit base material 12 at a predetermined position. In the following description, a conveyance direction of circuit base material 12 will be referred to as an X-direction, a horizontal direction perpendicular to that direction will be referred to as a Y-direction, and a vertical direction will be referred to as a Z-direction. That is, the width direction of component mounter 10 is the X-direction, and the front-rear direction is the Y-direction.

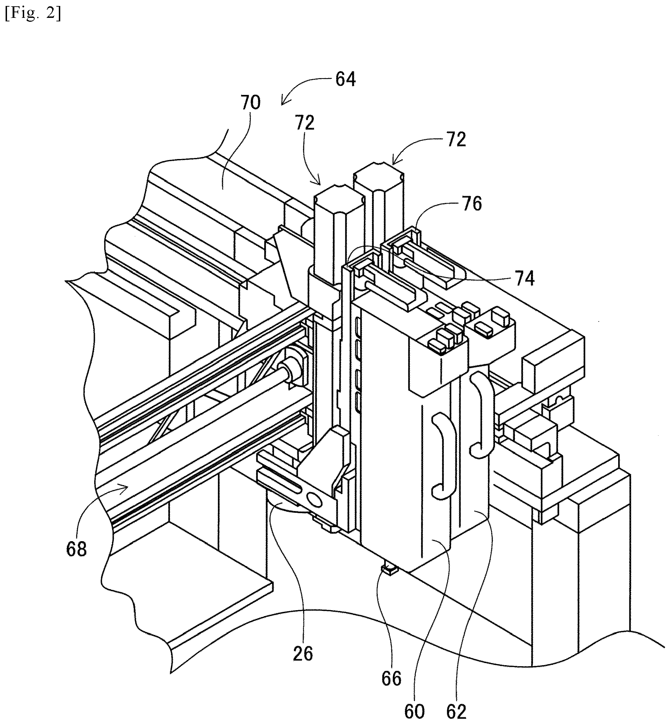

Component mounting device 24 is disposed on beam 42 and includes two work heads 60 and 62 and work head moving device 64. Work heads 60 and 62 each include suction nozzle (refer to Fig. 2) 66 and hold a component by using suction nozzle 66. Work head moving device 64 includes X-direction moving device 68, Y-direction moving device 70, and Z-direction moving device 72. Two work heads 60 and 62 integrally move to any position on frame 40 by X-direction moving device 68 and Y-direction moving device 70. As illustrated in Fig. 2, each of work heads 60 and 62 is detachably positioned and attached to sliders 74 and 76 without the use of a tool by an operator, so that Z-direction moving device 72 individually moves sliders 74 and 76 in the up-down direction. That is, work heads 60 and 62 are individually moved in the up-down direction by Z-direction moving device 72.

Imaging device 26 is attached to slider 74 in a state of being directed downward on the vertical line, and moves in the X-direction, the Y-direction, and the Z-direction together with work head 60. Consequently, imaging device 26 images any position on frame 40. As illustrated in Fig. 1, imaging device 28 is disposed between base material conveyance/holding device 22 and component supply device 30 on frame 40 in a state of being directed upward on the vertical line. Consequently, imaging device 28 images components held by suction nozzles 66 of work heads 60 and 62.

Component supply device 30 is disposed at a first end part of frame 40 in the front-rear direction. Component supply device 30 includes tray-type component supply device 78 and a feeder-type component supply device (not illustrated). Tray-type component supply device 78 is a device that supplies a component in a state of being placed on a tray. The feeder-type component supply device is a device that supplies components by using a tape feeder (not illustrated) and a stick feeder (not illustrated).

Bulk component supply device 32 is disposed at a second end part of frame 40 in the front-rear direction. Bulk component supply device 32 is a device that aligns multiple components in a scattered state and supplies the components in an aligned state. That is, bulk component supply device 32 is a device that aligns multiple components in any posture into a predetermined posture, and supplies the components in the predetermined posture. Hereinafter, a configuration of component supply device 32 will be described in detail. Examples of components which are supplied by component supply device 30 and bulk component supply device 32 include electronic circuit components, components of a solar cell, and components of a power module. The electronic circuit component may be a component having leads, a component without leads, or the like.

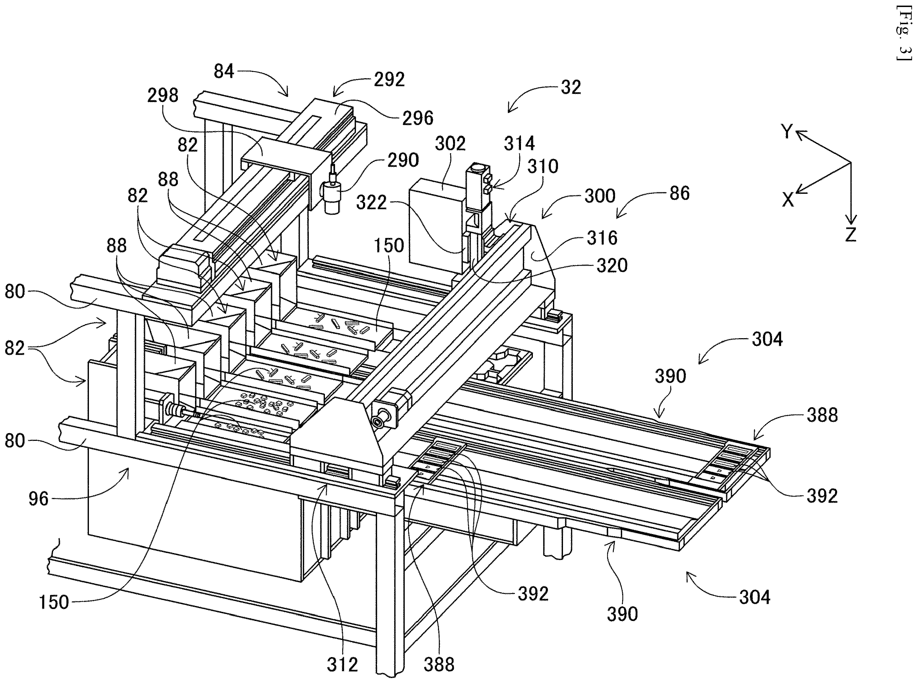

Bulk component supply device 32, as illustrated in Fig. 3, has main body 80, component supply unit 82, imaging device 84, and component delivery device 86.

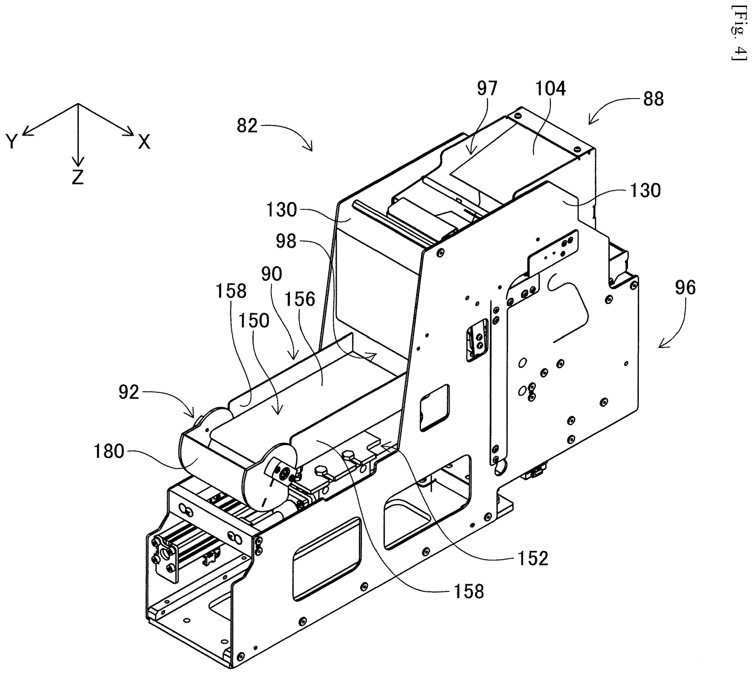

Component supply unit 82 includes component feeder 88, component scattering device (refer to Fig. 4) 90, and component return device (refer to Fig. 4) 92, and component feeder 88, component scattering device 90, and component return device 92 are integrally configured. Component supply unit 82 is detachably assembled to base 96 of main body 80, and in bulk component supply device 32, five component supply units 82 are arranged side by side in one row in the X-direction.

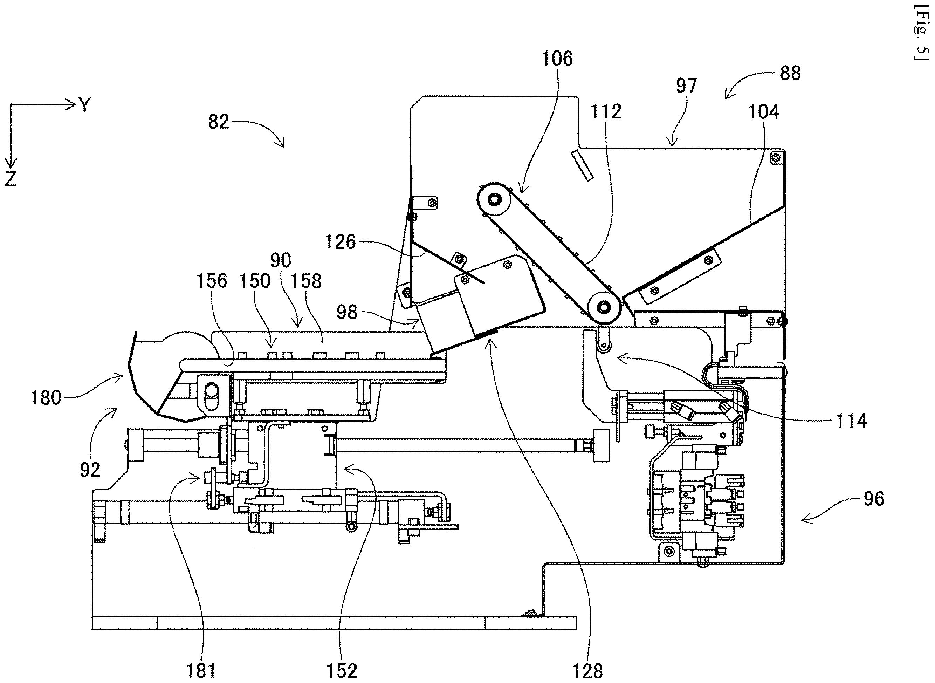

Component feeder 88 has a box shape that is a generally rectangular parallelepiped, as illustrated in Figs. 4 and 5, and is disposed to extend in the Y-direction. The Y-direction will be referred to as the front-rear direction of component feeder 88, and in component supply unit 82, the direction toward the side on which component return device 92 is disposed will be referred to as the front, and the direction toward the side on which component feeder 88 is disposed will be referred to as the rear.

Component feeder 88 is open at the upper and front surfaces, and the opening at the upper surface is input port 97 for components and the opening at the front surface is discharge port 98 for components. In component feeder 88, inclined plate 104 is disposed below input port 97. Inclined plate 104 is directed toward the center from the rear end surface of component feeder 88 and is disposed to be inclined downward.

As illustrated in Fig. 5, conveyor device 106 is disposed in front of inclined plate 104. Conveyor device 106 is disposed to be inclined upward from the front end part of inclined plate 104 toward the front of component feeder 88. Conveyor belt 112 of conveyor device 106 rotates counterclockwise in Fig. 5. That is, the conveyance direction of conveyor device 106 is obliquely upward from the front end part of inclined plate 104 to the front.

Inclined plate 126 is disposed below the front end part of conveyor device 106. Inclined plate 126 is disposed to extend from the front end surface of component feeder 88 toward below conveyor device 106, and the rear end part of inclined plate 126 is inclined obliquely downward. Inclined plate 128 is also disposed below inclined plate 126. Inclined plate 128 is inclined from below the central portion of conveyor device 106 toward discharge port 98 of component feeder 88 such that the front end part thereof is located downward.

As illustrated in Fig. 4, pair of side frames 130 are assembled to base 96. Pair of side frames 130 are erected to extend parallel to each other and in the Y-direction while facing each other. A distance between pair of side frames 130 is slightly larger than a dimension of component feeder 88 in the width direction, and thus component feeder 88 is detachably attached between pair of side frames 130.

Component scattering device 90 includes component support member 150 and component support member moving device 152. Component support member 150 includes stage 156 and pair of side wall portions 158. Stage 156 has a generally longitudinal plate-like shape and is disposed to extend to the front from below component feeder 88 attached between pair of side frames 130. The upper surface of stage 156 is generally horizontal and is disposed, as illustrated in Fig. 5, with a slight clearance with respect to the front end part of inclined plate 128 of component feeder 88. As illustrated in Fig. 4, pair of side wall portions 158 are erected on both side portions in the longitudinal direction of stage 156 and fixed, and the upper end of each side wall portion 158 extends above the upper surface of stage 156.

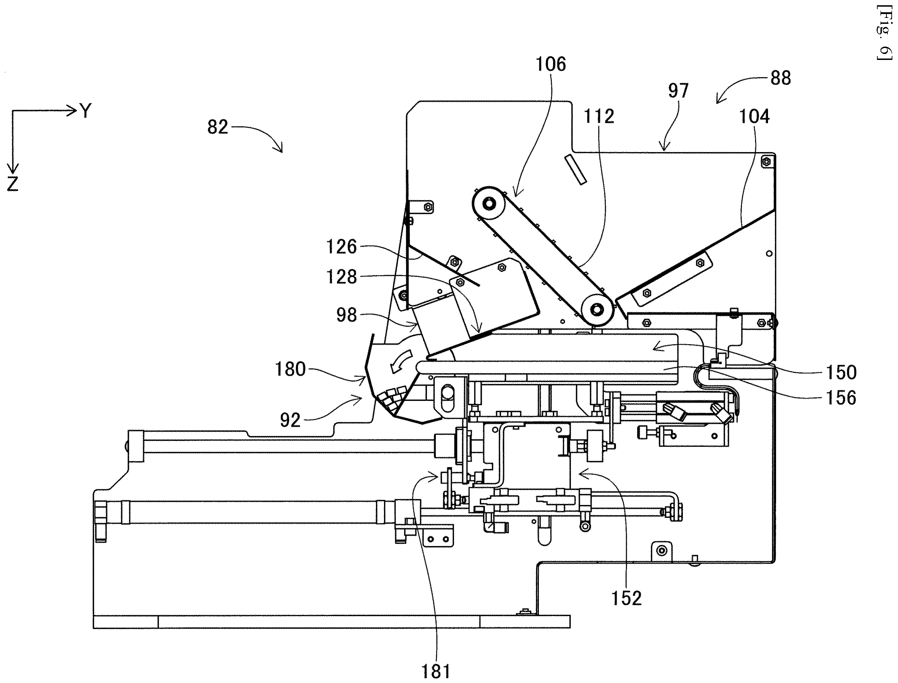

Component support member moving device 152 slides component support member 150 in the Y-direction as a result of an operation of air cylinder (refer to Fig. 11) 166. In this case, component support member 150 moves between a retracted state (refer to Fig. 6) in which component support member 150 is retracted below component feeder 88 and an exposed state (refer to Fig. 5) in which component support member 150 is exposed from underneath component feeder 88.

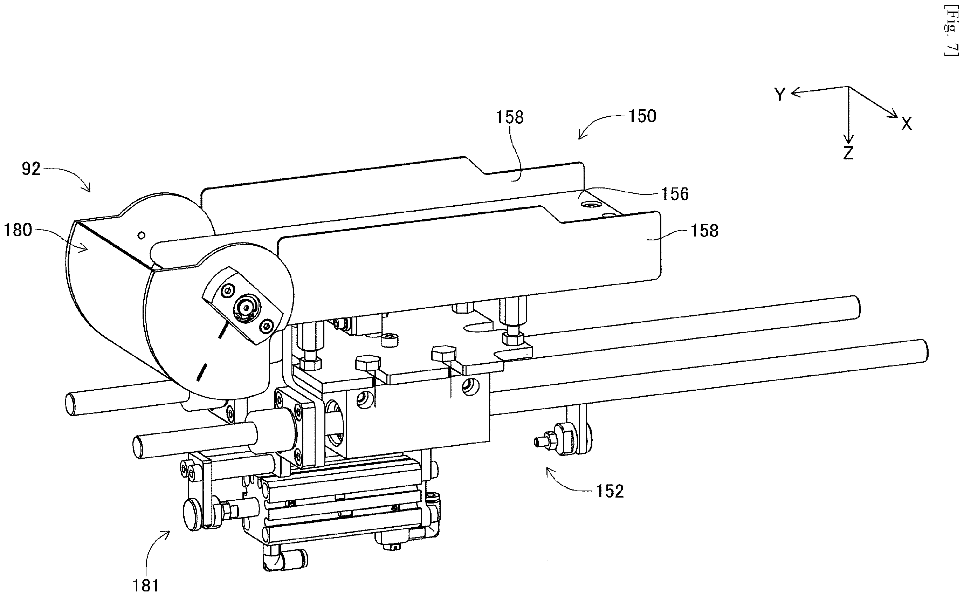

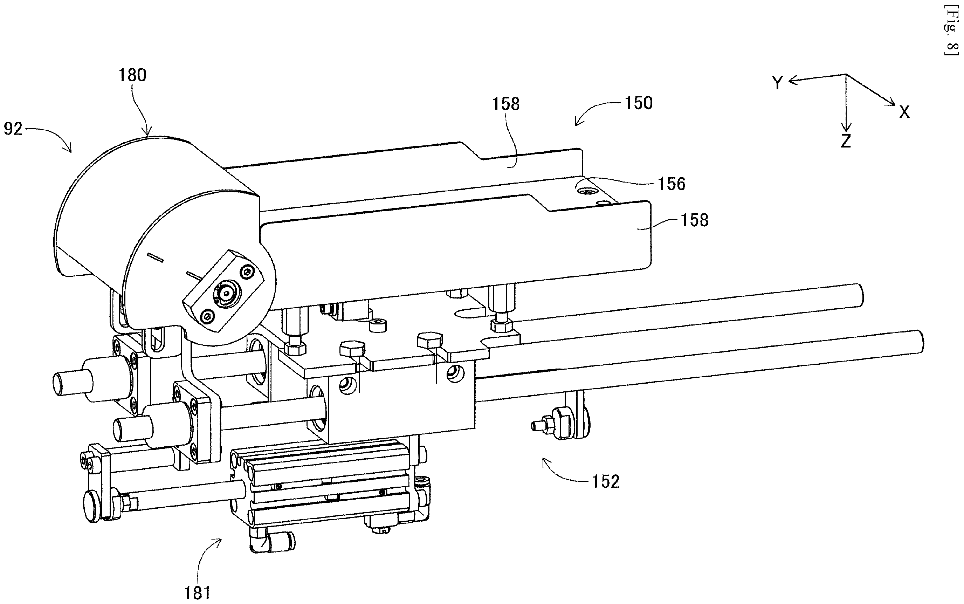

As illustrated in Fig. 7, component return device 92 includes component accommodation container 180 and container swing device 181. Component accommodation container 180 has a generally box-like shape and an arc-shaped bottom surface. Component accommodation container 180 is held in a swingable manner at the front end part of stage 156 of component support member 150 and is swung through an operation of container swing device 181. In this case, component accommodation container 180 is swung between an accommodation posture with the opening directed upward (refer to Fig. 7) and a return posture with the opening directed toward the upper surface of stage 156 of component support member 150 (refer to Fig. 8).

As illustrated in Fig. 3, imaging device 84 includes camera 290 and camera moving device 292. Camera moving device 292 includes guide rail 296 and slider 298. Guide rail 296 is fixed to main body 80 above component feeder 88 to extend in the width direction (X-direction) of bulk component supply device 32. Slider 298 is attached to guide rail 296 in a slidable manner and is slid to any position through an operation of electromagnetic motor 299 (refer to Fig. 11). Camera 290 is attached on slider 298 in such a state that camera 290 is directed downward.

Component delivery device 86 includes, as illustrated in Fig. 3, component holding head moving device 300, component holding head 302, and two shuttle devices 304.

Component holding head moving device 300 includes X-direction moving device 310, Y-direction moving device 312, and Z-direction moving device 314. Y-direction moving device 312 has Y-slider 316 disposed above component supply unit 82 to extend in the X-direction and Y-slider 316 is moved to any position in the Y-direction through driving of electromagnetic motor (refer to Fig. 11) 319. X-direction moving device 310 has X-slider 320 disposed on a side surface of Y-slider 316, and X-slider 320 is moved to any position in the X-direction through driving of electromagnetic motor (refer to Fig. 11) 321. Z-direction moving device 314 includes Z-slider 322 disposed on a side surface of X-slider 320, and Z-slider 322 is moved to any position in the Z-direction through driving of electromagnetic motor (refer to Fig. 11) 323.

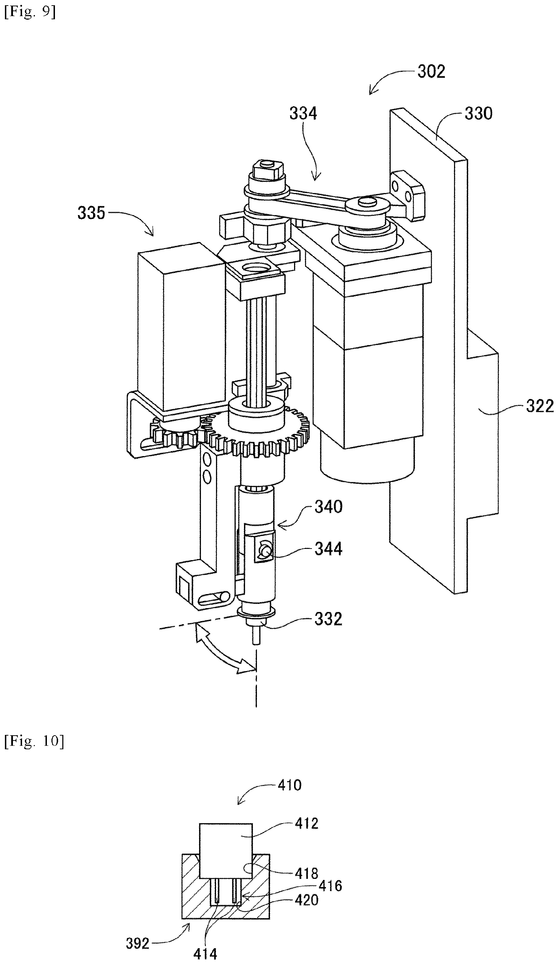

Component holding head 302 includes head main body 330, suction nozzle 332, nozzle pivoting device 334, and nozzle rotation device 335, as illustrated in Fig. 9. Head main body 330 is formed integrally with Z-slider 322. Suction nozzle 332 holds a component and is detachably attached to a lower end part of holder 340. Holder 340 is bendable at support shaft 344, and holder 340 is bent upward by 90 degrees through an operation of nozzle pivoting device 334. Consequently, suction nozzle 332 attached to the lower end part of holder 340 is pivoted by 90 degrees and is located at a pivoted position. That is, suction nozzle 332 is pivoted between a non-pivoted position and a pivoted position through an operation of nozzle pivoting device 334. Of course, suction nozzle 332 may be positioned to stop at an angle position between the non-pivoted position and the pivoted position. Nozzle rotation device 335 also rotates suction nozzle 332 around the axial center.

As illustrated in Fig. 3, each of two shuttle devices 304 includes component carrier 388 and component carrier moving device 390, and is fixed to main body 80 side by side in the lateral direction on the front side of component supply unit 82. Five component receiving members 392 which are arranged side by side in a row in the lateral direction are attached to component carrier 388, and a component is placed on each component receiving members 392.

Bulk component supply device 32 can supply various types of components, and thus, various types of component receiving members 392 are prepared depending on shapes of the components. Here, as an electronic circuit component supplied by bulk component supply device 32, as illustrated in Fig. 10, component receiving member 392 corresponding to lead component 410 having leads will be described. Lead component 410 includes component main body 412 having a block-like shape and two leads 414 that project from a bottom surface of component main body 412.

Component receiving member 392 is provided with component receiving recessed portion 416 having a shape corresponding to lead component 410. Component receiving recessed portion 416 is a recessed portion having a stepped shape and includes main body portion receiving recessed portion 418 that is open to an upper surface of component receiving member 392, and lead receiving recessed portion 420 that is open to a bottom surface of main body portion receiving recessed portion 418. Lead component 410 is inserted into the inside of component receiving recessed portion 416 in a posture in which leads 414 are directed downward. As a result, lead 414 is inserted into lead receiving recessed portion 420, and lead component 410 is placed inside of component receiving recessed portion 416 in a state in which component main body 412 is inserted into main body portion receiving recessed portion 418.

Component carrier moving device 390 is a plate-like longitudinal member and is disposed on the front side of component supply unit 82 in such a manner as to extend in the front-rear direction, as illustrated in Fig. 3. Component carrier 388 is disposed on the upper surface of component carrier moving device 390 to be slidable in the front-rear direction, and is slid to any position in the front-rear direction through driving of electromagnetic motor (refer to Fig. 11) 430. When component carrier 388 is slid in a direction of approaching component supply unit 82, component carrier 388 is slid to a component receiving position located within a range in which component holding head 302 is movable by component holding head moving device 300. On the other hand, when component carrier 388 is slid in a direction of moving away from component supply units 82, component carrier 388 is slid to a component supply position located within a range in which work heads 60 and 62 are movable by work head moving device 64.

As illustrated in Fig. 11, control device 34 includes integrated control device 450, multiple individual control devices (only one control device is illustrated in Fig. 11) 452, and image processing device 454. Integrated control device 450 is mainly configured with a computer and is connected to base material conveyance/holding device 22, component mounting device 24, imaging device 26, imaging device 28, component supply device 30, and bulk component supply device 32. Consequently, integrated control device 450 integrally controls base material conveyance/holding device 22, component mounting device 24, imaging device 26, imaging device 28, component supply device 30, and bulk component supply device 32. Multiple individual control devices 452 are configured mainly with a computer, and are provided corresponding with base material conveyance/holding device 22, component mounting device 24, imaging device 26, imaging device 28, component supply device 30, and bulk component supply device 32 (in Fig. 11, only individual control device 452 corresponding to bulk component supply device 32 is illustrated).

Individual control device 452 of bulk component supply device 32 is connected to component scattering device 90, component return device 92, camera moving device 292, component holding head moving device 300, component holding head 302, and shuttle device 304. Thus, individual control device 452 of bulk component supply device 32 controls component scattering device 90, component return device 92, camera moving device 292, component holding head moving device 300, component holding head 302, and shuttle device 304. Image processing device 454 is connected to imaging device 84 and processes imaging data captured by imaging device 84. Image processing device 454 is connected to individual control device 452 of bulk component supply device 32. As a result, individual control device 452 of bulk component supply device 32 acquires imaging data that is captured by imaging device 84.

Bulk component supply device 32 has storage device 458. Storage device 458 is connected to individual control device 452 and stores various types of information in response to a command from individual control device 452. Individual control device 452 is also connected to information processing device 460. As will be described in detail later, information processing device 460 creates image data used to hold components scattered on stage 156, and individual control device 452 acquires the image data created by information processing device 460.

With the configuration that has been described, component mounter 10 executes component mounting work on circuit base material 12 held by base material conveyance/holding device 22. Specifically, circuit base material 12 is conveyed to a work position and held at that position in a fixed manner by clamp device 52. Next, imaging device 26 is moved above circuit base material 12 and images circuit base material 12. Consequently, information regarding an error in the holding position of circuit base material 12 is obtained. Component supply device 30 or bulk component supply device 32 supplies a component at a predetermined supply position. The supply of a component by bulk component supply device 32 will be described in detail later. Either of work head 60 or 62 is moved above the component supply position to hold a component with suction nozzle 66. Subsequently, work head 60 or 62 that holds the component is moved above imaging device 28, and the component held by suction nozzle 66 is imaged by imaging device 28. Consequently, information regarding an error in the holding position of the component is obtained. Work head 60 or 62 holding the component is moved above circuit base material 12, and attaches the held component onto circuit base material 12 after correcting the error in the holding position of circuit base material 12, the error in the holding position of the component, and the like.

In bulk component supply device 32, lead components 410 are input by an operator from input port 97 of component feeder 88, and input lead component 410 is supplied in a state of being placed on component receiving member 392 of component carrier 388 through operations of component supply unit 82 and component delivery device 86.

Specifically, the operator inputs lead components 410 from input port 97 on the upper surface of component feeder 88. In this case, the operator inputs one type of lead component. It should be noted that when one type of component is input from input port 97, component support member 150 is moved to the lower side of component feeder 88 through an operation of component support member moving device 152, and thus component support member 150 is brought into a retracted state (refer to Fig. 6). When component support member 150 is in the retracted state, component accommodation container 180 disposed at the front end part of component support member 150 is located in front of component feeder 88, and has a posture (accommodation posture) in which the opening of component accommodation container 180 is directed upward.

Lead component 410 input from input port 97 of component feeder 88 falls on inclined plate 104 of component feeder 88 and rolls down to the front lower end of inclined plate 104. Lead components 410 that have rolled down to the front lower end of inclined plate 104 are piled up between the front lower end of inclined plate 104 and the rear lower end of conveyor device 106. Conveyor belt 112 of conveyor device 106 is rotated counterclockwise in Fig. 6 through an operation of conveyor device 106. Consequently, lead components 410 piled up between inclined plate 104 and conveyor belt 112 are conveyed obliquely upward by conveyor belt 112.

Lead components 410 conveyed by conveyor belt 112 fall onto inclined plate 126 from the front upper end of conveyor device 106. Lead components 410 that have fallen on inclined plate 126 roll down rearward on inclined plate 126 to fall onto inclined plate 128. Lead components 410 that have fallen on inclined plate 128 roll down toward the front and are discharged from discharge port 98 on the front side of component feeder 88.

Consequently, lead components 410 discharged from discharge port 98 of component feeder 88 are accommodated inside component accommodation container 180. When a predetermined amount of lead components 410 is discharged from component feeder 88, that is, when conveyor device 106 is operated by a certain amount, conveyor device 106 is stopped. Next, component support member 150 is moved from the retracted state toward the front through an operation of component support member moving device 152.

Container swing device 181 of component return device 92 operates to swing component accommodation container 180 at a timing at which component support member 150 has been moved a predetermined amount from the retracted state toward the front. Consequently, a posture of component accommodation container 180 changes vigorously from a posture (accommodation posture) in which the opening is directed upward to a posture (return posture) in which the opening is directed toward stage 156. In this case, lead components 410 accommodated in component accommodation container 180 are vigorously released toward stage 156. Consequently, lead components 410 are scattered on stage 156 from component accommodation container 180.

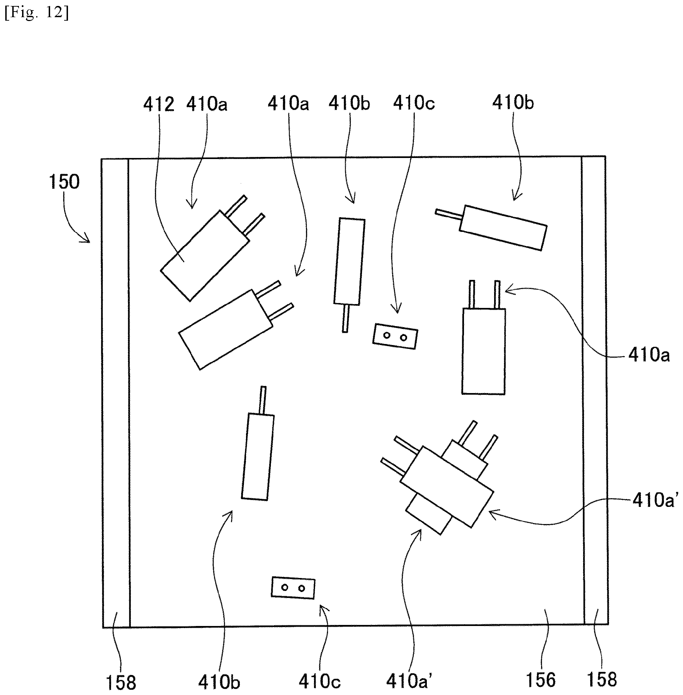

It should be noted that when lead components 410 are scattered on stage 156 of component support member 150, as illustrated in Fig. 12, a component that contacts only the upper surface of the stage and is not in contact with other scattered components or members among scattered lead components 410 is scattered on stage 156 in approximately three postures. Specifically, in the first posture, lead components 410 are scattered in a posture in which the surface from which lead 414 extends is directed laterally and two leads 414 are generally aligned horizontally. In the second posture, lead components 410 are scattered in a posture in which the surface from which lead 414 extends is directed laterally and two leads 414 are generally aligned vertically. In the third posture, lead components 410 are scattered in a posture in which the surface from which lead 414 extends is directed upward. When lead components 410 are distinguished according to a scattering posture, the lead components are described as lead component 410a in the first posture, lead component 410b in the second posture, and lead component 410c in the third posture.

When lead components 410 are scattered on stage 156 as described above, camera 290 of imaging device 84 is moved above component support member 150 through an operation of camera moving device 292. Lead components 410 scattered on stage 156 are then imaged by camera 290. Since an angle of view of camera 290, that is, an imaging range is larger than stage 156, the entire stage 156, that is, all lead components 410 scattered on stage 156 are imaged through imaging performed once. Based on the imaging data captured by camera 290, a lead component that is a pickup target (hereinafter, referred to as a "pickup target component") is determined.

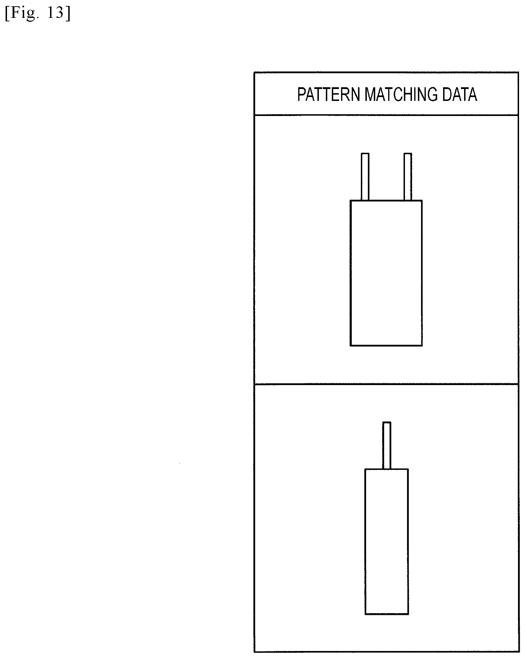

Specifically, based on the imaging data regarding all lead components 410 scattered on stage 156 obtained by camera 290, an outline of lead component 410 is specified, and a shape of the upper surface of lead component 410, that is, a shape from the viewpoint from the upper side of lead component 410 is calculated. Storage device 458 stores image data regarding a component for pattern matching (hereinafter, referred to as "pattern matching data) for specifying a pickup target component through pattern matching. The pattern matching data is image data indicating the outline of lead component 410, and as illustrated in Fig. 13, the image data indicating the outline of lead component 410a in the first posture (hereinafter, referred to as "first posture component outline data") and the image data indicating the outline of lead component 410b in the second posture (hereinafter, referred to as "second posture component outline data") are stored as pattern matching data.

It is determined whether shapes of the outlines of all lead components 410 scattered on stage 156 calculated based on the imaging data (hereinafter, referred to as "imaged component shapes") coincide with the shapes of the outlines of lead components 410 based on the first posture component outline data (hereinafter, referred to as "first stored component shapes") or the shapes of the outlines of lead components 410 based on the second posture component outline data (hereinafter, referred to as second stored component shapes).

It should be noted that an allowable coincidence ratio is also stored in storage device 458 together with the pattern matching data, and thus in a case where a coincidence ratio between the imaged component shape of each of all the lead components scattered on stage 156 and the first stored component shape or the second stored component shape exceeds the allowable coincidence ratio, it is determined that the imaged component shape of each of the lead components scattered on stage 156 coincides with the first stored component shape or the second stored component shape. That is, for example, in a case where the allowable coincidence ratio is set to 90%, the individual control device determines that the imaged component shape coincides with the first stored component shape or the second stored component shape for a lead component whose coincidence ratio between the imaged component shape of each of all the lead components scattered on stage 156 and the first stored component shape or the second stored component shape exceeds 90%. The individual control device recognizes lead component 410 determined by the individual control device as a pickup target component when the imaged component shape of each of all the lead components scattered on stage 156 coincides with the first stored component shape or the second stored component shape.

That is, the individual control device recognizes lead component 410a in the first posture and lead component 410b in the second posture as pickup target components, and does not recognize lead component 410c in the third posture as a pickup target component. This is because in lead component 410c in the third posture, lead 414 is disposed on the upper surface such that lead 414 obstructs suction nozzle 332, and thus lead component 410 cannot be appropriately held. As a result, among multiple components scattered on stage 156, lead component 410a in the first posture and lead component 410b in the second posture that can be held by suction nozzle 332 are recognized as pickup target components.

However, even in a case where lead component 410a in the first posture and lead component 410b in the second posture are recognized as pickup target components, when the one component overlaps another component, there is a possibility that the pickup target component cannot be appropriately held, or a possibility that suction nozzle 332 is broken when the pickup target component is held. In other words, in a case where a component that is recognized as a pickup target component overlaps another component, and an upper surface of the pickup target component is not horizontal, there is a possibility that the component cannot be appropriately held by suction nozzle 332. Although a lowering position of suction nozzle 332 when the component is held by suction nozzle 332 is set in advance, since the pickup target component overlaps another component, the upper surface of the pickup target component becomes higher than the lowering position of suction nozzle 332, so that suction nozzle 332 vigorously abuts on the pickup target component when suction nozzle 332 is lowered, and thus suction nozzle 332 may be broken.

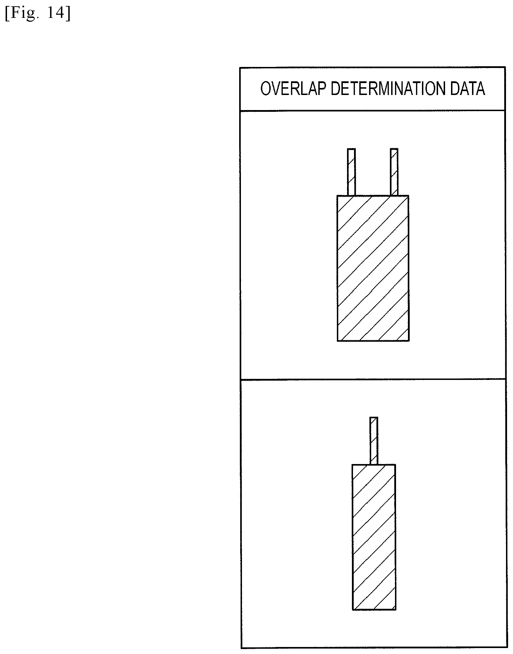

Thus, storage device 458 also stores image data of a component (hereinafter, referred to as "overlap determination data") for determining whether one pickup target component overlaps another component. The overlap determination data is image data indicating the brightness of a lead component, and as illustrated in Fig. 14, image data indicating the brightness inside the outline of lead component 410a in the first posture (hereinafter, referred to as "first posture component brightness data") and image data indicating the brightness inside the outline of lead component 410b in the second posture (hereinafter, referred to as "second posture component brightness data") are stored as overlap determination data.

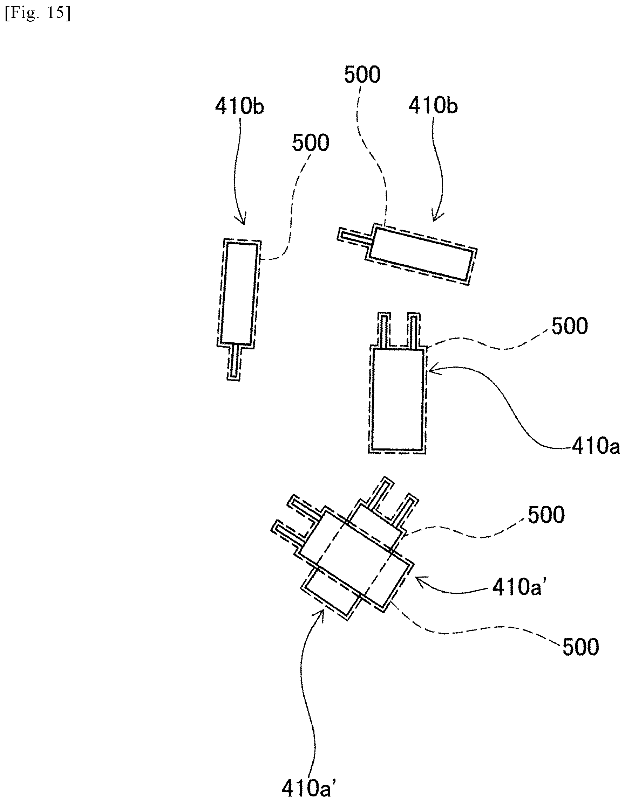

Based on the pattern matching data, the individual control device calculates a line (hereinafter, referred to as a "component extension line") 500 in which an outline of the imaging data of the lead component recognized as a pickup target component is extended by a predetermined dimension, for example, 1 mm, to the outside in the imaging data of the lead component as illustrated in Fig. 15. The individual control device also calculates the internal brightness of component extension line 500 (hereinafter, referred to as "component extension line internal brightness"). Storage device 458 stores the brightness of stage 156 (hereinafter, referred to as "stage brightness"), and the overlap determination process on the component is performed based on the stage brightness, the component extension line internal brightness, and the overlap determination data.

Specifically, in a case where lead component 410a in the first posture is recognized as a pickup target component, for example, the individual control device compares the brightness of the lead component based on the first posture component brightness data stored in the storage device (hereinafter, referred to as "first stored component brightness") with the component extension line internal brightness in the imaging data, and thus specifies the brightness of a portion different between the first stored component brightness and the component extension line internal brightness. The brightness of a portion different between the first stored component brightness and the component extension line internal brightness is the brightness of the portion between the outline of the lead component and component extension line 500, and is the brightness of the background of the lead component in the image based on the imaging data. Thus, the brightness of the portion between the first stored component brightness and the component extension line internal brightness will be referred to as the component background brightness.

If the component background brightness is the same as the stage brightness stored in storage device 458, the background of the lead component in the image based on the imaging data is determined to be stage 156, and the determination target component is determined to be a component that does not overlap another component. In other words, in a case where lead component 410a among multiple lead components scattered as illustrated in Fig. 15 is a determination target component, the background of lead component 410a is only stage 156, and the component background brightness of lead component 410a is equal to the stage brightness. Thus, it is determined that lead component 410a is a component that does not overlap another component. On the other hand, in a case where the component background brightness differs from the stage brightness stored in storage device 458, it is determined that there is an object other than stage 156 in the background of the lead component in the image based on the imaging data, and it is determined that the determination target component is a component that overlaps another component. In other words, in a case where lead component 410a' in Fig. 15 is a determination target component, since not only stage 156 but also another component is included in the background of lead component 410a', the component background brightness of lead component 410a' is not equal to the stage brightness. That is, the component background brightness of lead component 410a' is different from the stage brightness. Therefore, it is determined that lead component 410a' overlaps another component.

As described above, the individual control device executes the overlap determination process on components based on the overlap determination data, and determines, as a pickup target component, a component that is a determination target component determined as not overlapping another component in the overlap determination process. That is, first, the individual control device recognizes a pickup target component based on the pattern matching data, and in a case where it is determined that the recognized pickup target component does not overlap another component based on the overlap determination data, the component is determined as the pickup target component.

Position information and the like of lead component 410 determined as a pickup target component are calculated based on the imaging data. Next, based on the calculated position information of the pickup target component, component holding head 302 is moved above a pickup target component through an operation of component holding head moving device 300 and the pickup target component is picked up and held by suction nozzle 332. When the pickup target component is being picked up and held by suction nozzle 332, suction nozzle 332 is located at the non-pivoted position.

Next, component holding head 302 is moved above component carrier 388 after lead component 410 is held by suction nozzle 332. In this case, component carrier 388 is then moved to the component receiving position through an operation of component carrier moving device 390. When component holding head 302 is moved above component carrier 388, suction nozzle 332 is pivoted to the pivoted position. Suction nozzle 332 is pivoted through an operation of nozzle rotation device 335 such that lead 414 of lead component 410 held by suction nozzle 332 at the pivoted position is directed downward in the vertical direction.

When component holding head 302 is moved above component carrier 388, lead component 410 of which lead 414 is directed downward in the vertical direction is inserted into component receiving recessed portion 416 of component receiving member 392. Consequently, lead component 410 is placed on component receiving member 392 in a state in which lead 414 is directed downward in the vertical direction, as illustrated in Fig. 10.

When lead component 410 is placed on component receiving member 392, component carrier 388 is moved to the component supply position through an operation of component carrier moving device 390. Component carrier 388 moved to the component supply position is located within the moving range of work heads 60 and 62, and thus lead component 410 is supplied to component mounter 10 at this position in bulk component supply device 32. As described above, in bulk component supply device 32, lead component 410 is supplied such that lead 414 is directed downward and the upper surface is directed upward, the upper surface being a surface opposing the bottom surface connected to lead 414. Consequently, suction nozzles 66 of work heads 60 and 62 can suitably hold corresponding lead components 410.

As described above, in bulk component supply device 32, from multiple components scattered on stage 156, a pickup target component is determined based on the pattern matching data and the overlap determination data, and the determined pickup target component is supplied. However, in a case where appropriate data is not stored in storage device 458 as the pattern matching data and the overlap determination data, there is a possibility that an appropriate component cannot be supplied.

Specifically, the pattern matching data and the overlap determination data are created in information processing device 460 connected to the individual control device. Specifically, first, at a timing at which work is not executed in component mounter 10, components for creating the pattern matching data and the overlap determination data are placed on stage 156. In this case, for example, in a case where the pattern matching data and the overlap determination data of the lead component in the first posture are created, an operator places lead component 410 on stage 156 in the first posture. The lead component in the first posture is imaged by imaging device 84, and imaging data created through the imaging is input to information processing device 460.

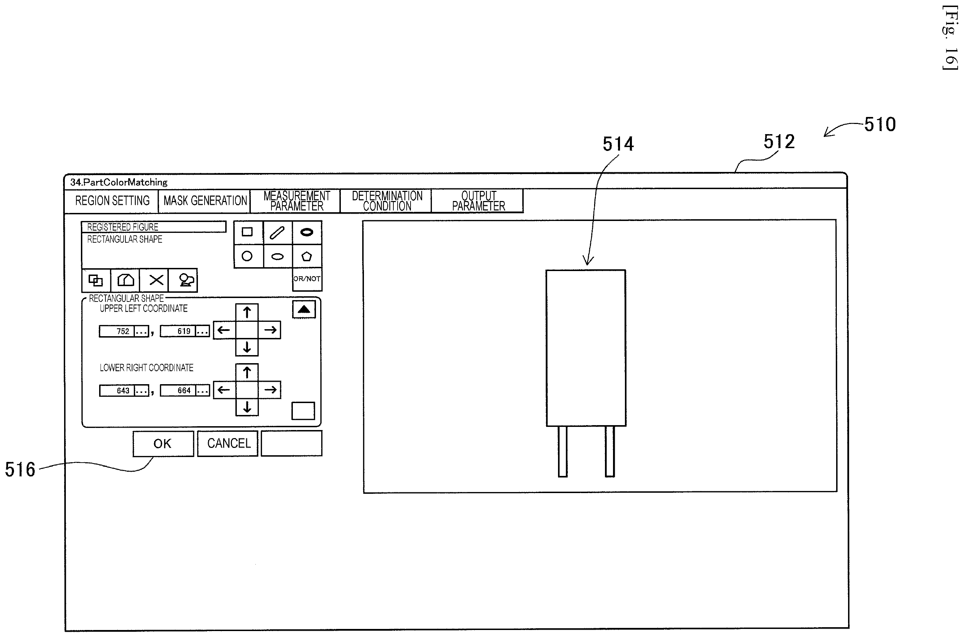

When a new creation button for creating the new pattern matching data and overlap determination data is operated in information processing device 460, first creation screen 512 for creating pattern matching data is displayed on monitor 510 of information processing device 460 as illustrated in Fig. 16. In information processing device 460, an outline of lead component 410 is calculated based on the imaging data, and image 514 indicating the outline of lead component 410 is displayed on first creation screen 512. In this case, when the operator checks image 514 displayed on first creation screen 512 and registers the outline of the lead component indicated by image 514 as the pattern matching data of the lead component in the first posture, the operator operates OK button 516. As a result, information processing device 460 registers data regarding the outline of the lead component indicated by image 514. In first creation screen 512, the operator also inputs an allowable coincidence ratio used when recognizing a pickup target component by using the pattern matching data. Thus, due to the input of the operator, information processing device 460 also registers the allowable coincidence ratio together with the data regarding the outline of the lead component.

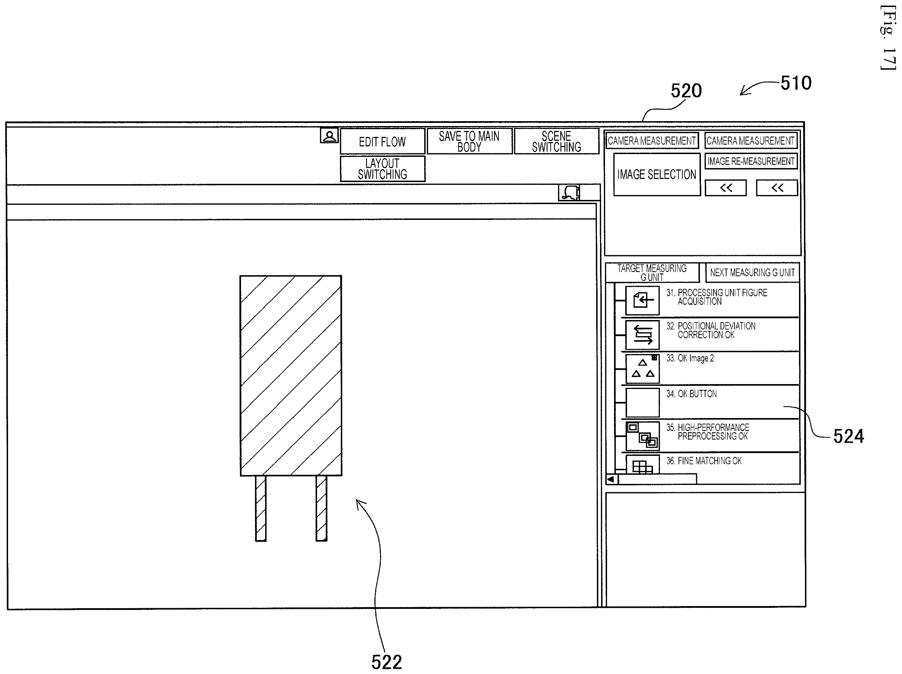

When OK button 516 is operated, second creation screen 520 for creating the overlap determination data is displayed on monitor 510 as illustrated in Fig. 17 instead of first creation screen 512. In information processing device 460, the brightness inside the outline of lead component 410 is calculated based on the imaging data, and image 522 indicating the brightness inside the outline of lead component 410 is displayed on second creation screen 520. In this case, in a case where the operator checks image 522 displayed on second creation screen 520 and registers the brightness inside the outline of the lead component indicated by image 522 as the overlap determination data of the lead component in the first posture, the operator operates OK button 524. As a result, information processing device 460 registers the data regarding the brightness inside the outline of the lead component indicated by image 522. Information processing device 460 outputs the data regarding the outline of the lead component registered in first creation screen 512, the allowable coincidence ratio input on first creation screen 512, and the data regarding the brightness inside the outline of the lead component registered in second creation screen 520 to storage device 458. As a result, storage device 458 stores the data regarding the outline of the lead component as the pattern matching data of the lead component in the first posture, and also stores the allowable coincidence ratio in association with the pattern matching data. Storage device 458 stores the data regarding the brightness inside the outline of the lead component as the overlap determination data of the lead component in the first posture.

As a result, as illustrated in Figs. 13 and 14, the pattern matching data and the overlap determination data of the lead component in the first posture are stored in storage device 458. Based on the pattern matching data and the overlap determination data stored in storage device 458, a pickup target component is determined according to the above-described method. However, in creating the pattern matching data and the overlap determination data, an operator may place an inappropriate lead component (hereinafter, referred to as a "defective component") such as a lead component of which lead 414 is bent or a lead component in which a chipping has occurred in component main body 412 on stage 156, image the defective component with imaging device 84, and input the imaging data to information processing device 460, for example. Images 514 and 522 based on the imaging data of the defective component are displayed on first creation screen 512 and second creation screen 520, but the operator may operate OK buttons 516 and 524 without appropriately checking images 514 and 522. In such a case, pattern matching data and overlap determination data created based on the imaging data of the defective component are stored in storage device 458.

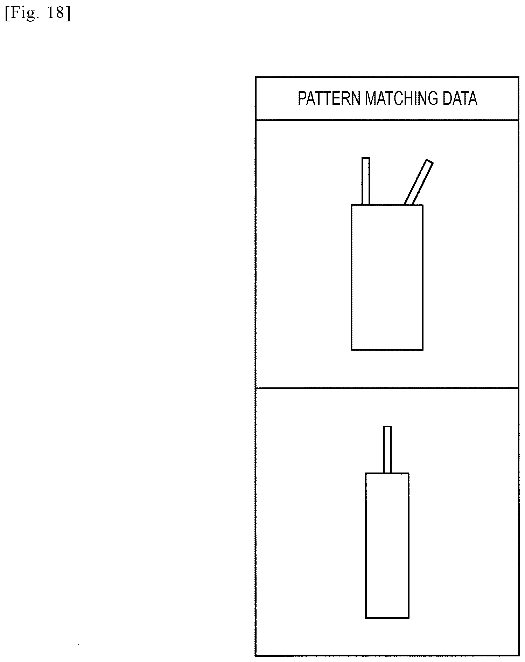

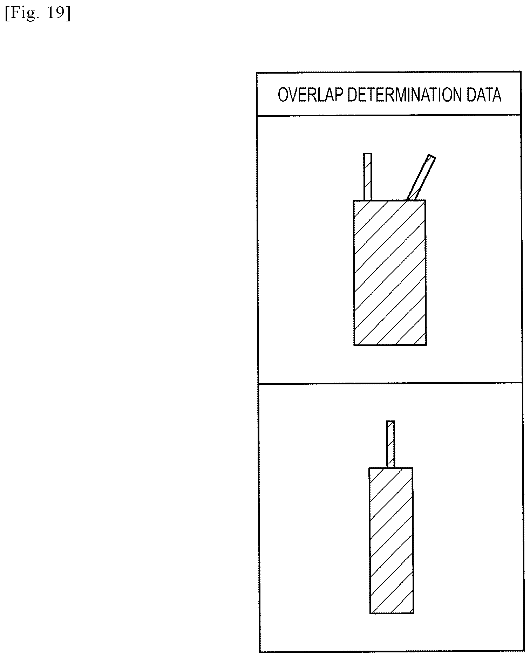

Specifically, for example, when the operator places a lead component of which lead 414 is bent on stage 156 and captures an image thereof, pattern matching data is created based on imaging data of the lead component of which lead 414 is bent, and as illustrated in Fig. 18, image data indicating an outline of the lead component of which lead 414 is bent is stored in storage device 458 as the pattern matching data in the first posture. Overlap determination data is created based on the imaging data of the lead component of which lead 414 is bent, and as illustrated in Fig. 19, image data indicating the brightness inside the outline of the lead component of which lead 414 is bent is stored in storage device 458 as the overlap determination data in the first posture. That is, the image data of the defective component is stored in storage device 458 as the pattern matching data and the overlap determination data.

As described above, when the image data of the defective component is stored in storage device 458 as the pattern matching data and the overlap determination data, there is a possibility that an appropriate component cannot be supplied to bulk component supply device 32. In other words, when a pickup target component is determined by using the pattern matching data and the overlap determination data illustrated in Figs. 18 and 19, there is a possibility that a lead component of which lead 414 is bent may be determined as a pickup target component, and the lead component of which lead 414 is bent may be supplied in bulk component supply device 32.

Therefore, in such a case, it is necessary to update the pattern matching data and the overlap determination data of the lead component in the first posture stored in storage device 458 to pattern matching data and overlap determination data of an appropriate lead component (hereinafter, referred to as a "normal component") such as a lead component of which a lead is not bent or a lead component in which no chipping has occurred. Therefore, the operator places a normal component on stage 156 in the first posture. The normal component in the first posture is imaged by imaging device 84, and imaging data of the normal component created through the imaging is input to information processing device 460.

In information processing device 460, when an update button for updating the data stored in storage device 458 is operated, as illustrated in Fig. 16, first creation screen 512 is displayed on monitor 510, and image 514 indicating an outline of the normal component is displayed on first creation screen 512. In this case, when the operator checks image 514 indicating the outline of the normal component displayed on first creation screen 512 and operates OK button 516, information processing device 460 registers data regarding the outline of the normal component indicated by image 514 and outputs the data to storage device 458. Storage device 458 then stores the data regarding the outline of the normal component indicated by image 514 in storage device 458 as the pattern matching data of the lead component in the first posture. In this case, storage device 458 erases the previously stored pattern matching data of the lead component in the first posture. That is, storage device 458 erases the previously stored pattern matching data of a defective component in the first posture, and also overwrites and stores the pattern matching data of the normal component in the first posture. As a result, the pattern matching data of the lead component in the first posture is updated, and as illustrated in Fig. 13, the data indicating the outline of the normal component in the first posture is stored in storage device 458 as the pattern matching data.

However, in a conventional storage device, overlap determination data is not updated even if pattern matching data of a lead component is updated. Specifically, when pattern matching data is updated, an allowable coincidence ratio can also be updated, for example, data indicating an outline of a normal component is registered by operating OK button 516 on first creation screen 512, and an allowable coincidence ratio is also input. The data indicating the outline of the normal component and the allowable coincidence ratio are output to the storage device, so that the allowable coincidence ratio is also updated together with the pattern matching data. On the other hand, the pattern matching data may be not updated, but only the allowable coincidence ratio may be updated. In other words, there may be a case where the operator does not want to update the pattern matching data, but wants to update only the allowable coincidence ratio. In such a case, the update button is operated in a state in which the imaging data is not input to information processing device 460 without imaging a component for updating the pattern matching data. In this case, image 514 indicating the outline of the component is not displayed on first creation screen 512. Thus, on first creation screen 512, the pattern matching data cannot be registered, but the allowable coincidence ratio can be input. As described above, on first creation screen 512, when only the allowable coincidence ratio is input without registering the pattern matching data, the pattern matching data is not output to the storage device, and only the allowable coincidence ratio is output to the storage device. As a result, in the storage device, the pattern matching data is not updated, but only the allowable coincidence ratio is updated. As described above, in some cases, the pattern matching data is updated in the storage device by operating the update button in information processing device 460, and in some cases, only the allowable coincidence ratio is updated without updating the pattern matching data. In a case where the pattern matching data is updated in the storage device, it is desirable to update the overlap determination data as well, but in a case where only the allowable coincidence ratio is updated without updating the pattern matching data, the overlap determination data is not required to be updated. In other words, in a case where the update button is operated in information processing device 460, since the overlap determination data is not necessarily updated, the overlap determination data is not updated even if the pattern matching data is updated. In such a case, in the storage device, the pattern matching data (the data indicating the outline of a defective component in the first posture) illustrated in Fig. 18 is updated to the pattern matching data (the data indicating the outline of a normal component in the first posture) illustrated in Fig. 13, but the overlap determination data (the data indicating the brightness inside the outline of the defective component in the first posture) illustrated in Fig. 19 is maintained without being updated. Thus, when a pickup target component is determined, the pattern matching data illustrated in Fig. 13 and the overlap determination data illustrated in Fig. 19 are used, but since the overlap determination data illustrated in Fig. 19 includes the data regarding the defective component, the overlap determination process cannot be appropriately performed.

Therefore, in storage device 458, data indicating the creation date and time of each piece of data is appended to the pattern matching data and the overlap determination data so that the overlap determination data is also necessarily updated when the pattern matching data is updated. Specifically, as described above, information processing device 460 is provided with the new creation button and the update button. New pattern matching data and overlap determination data are created by operating the new creation button, and the pattern matching data is updated by operating the update button. On the other hand, in information processing device 460 of the present invention, the new creation button and the update button are not distinguished from each other, and a creation button for creating the pattern matching data and the overlap determination data is prepared. By operating the creation button, creation of new pattern matching data and overlap determination data and update of the pattern matching data and the overlap determination data are executed.

Specifically, even when new pattern matching data and overlap determination data are created by operating the creation button, the operator places lead component 410 on stage 156 in the first posture, similarly to the conventional method. The lead component in the first posture is imaged by imaging device 84, and imaging data created through the imaging is input to information processing device 460. In information processing device 460, when the creation button is operated, first creation screen 512 illustrated in Fig. 16 is displayed on monitor 510 of information processing device 460. In information processing device 460, an outline of lead component 410 is calculated based on the imaging data, and image 514 indicating the outline of lead component 410 is displayed on first creation screen 512. In this case, when the operator checks image 514 displayed on first creation screen 512 and operates OK button 516, information processing device 460 registers the data regarding the outline of the lead component indicated by image 514. Since the allowable coincidence ratio is also input on first creation screen 512, information processing device 460 also registers the allowable coincidence ratio together with the data regarding the outline of the lead component.

When OK button 516 is operated on first creation screen 512, the data regarding the outline of the lead component and the allowable coincidence ratio are registered in the information processing device, and second creation screen 520 illustrated in Fig. 17 is displayed on monitor 510 instead of first creation screen 512. In information processing device 460, the brightness inside the outline of lead component 410 is calculated based on the imaging data, and image 522 indicating the brightness inside the outline of lead component 410 is displayed on second creation screen 520. In this case, when the operator checks image 522 displayed on second creation screen 520 and operates OK button 524, information processing device 460 registers the data regarding the brightness inside the outline of the lead component indicated by image 522. Information processing device 460 outputs the data regarding the outline of the lead component registered in first creation screen 512, the allowable coincidence ratio input on first creation screen 512, and the data regarding the brightness inside the outline of the lead component registered in second creation screen 520 to storage device 458. As a result, storage device 458 stores the data regarding the outline of the lead component as the pattern matching data of the lead component in the first posture, and also stores the allowable coincidence ratio in association with the pattern matching data. In this case, storage device 458 stores the date and time (hereinafter, "pattern matching storage date and time") at which the pattern matching data is stored together with the pattern matching data. Storage device 458 stores the data regarding the brightness inside the outline of the lead component as the overlap determination data of the lead component in the first posture. In this case, storage device 458 stores the date and time (hereinafter, "overlap determination storage date and time") at which the overlap determination data is stored together with the overlap determination data. Therefore, since the created new pattern matching data and overlap determination data are stored in storage device 458 at the same timing, the overlap determination storage date and time are the same as the pattern matching storage date and time.

After the new pattern matching data and overlap determination data are created by operating the creation button, the operator operates the creation button in a case where the operator desires to update the pattern matching data and the overlap determination data. Also in this case, as in the conventional method, the operator places an update target component, that is, a normal component, on stage 156 in the first posture. The normal component is imaged by imaging device 84, and imaging data created through the imaging is input to information processing device 460. In information processing device 460, when the creation button is operated, first creation screen 512 illustrated in Fig. 16 is displayed on monitor 510 of information processing device 460. In information processing device 460, an outline of the normal component is calculated based on the imaging data, and image 514 indicating the outline of the normal component is displayed on first creation screen 512. In this case, when the operator checks image 514 displayed on first creation screen 512 and operates OK button 516, information processing device 460 registers data regarding the outline of the normal component indicated by image 514 and outputs the data to storage device 458. Storage device 458 overwrites and saves the data regarding the outline of the normal component indicated by image 514 as the pattern matching data of the lead component in the first posture. That is, storage device 458 erases the pattern matching data of the lead component in the first posture stored previously together with the pattern matching storage date and time, and stores the data regarding the outline of the normal component in the first posture as pattern matching data of the lead component in the first posture. In this case, storage device 458 stores the pattern matching storage date and time together with the pattern matching data. That is, storage device 458 updates the previously stored pattern matching data in the first posture lead component to the pattern matching data of the normal component in the first posture, and stores the updated date and time as the pattern matching storage date and time together with the updated pattern matching data.

Storage device 458 then compares the pattern matching storage date and time stored together with the pattern matching data with the overlap determination storage date and time stored together with the overlap determination data. In this case, when the pattern matching data is updated, the pattern matching storage date and time stored together with the pattern matching data is later than the overlap determination storage date and time stored together with the overlap determination data. Therefore, in a case where the pattern matching storage date and time stored together with the pattern matching data is later than the overlap determination storage date and time stored together with the overlap determination data, the overlap determination data is also updated. In other words, in a case where the pattern matching storage date and time stored together with the pattern matching data is later than the overlap determination storage date and time stored together with the overlap determination data, information processing device 460 calculates the brightness inside the outline of the normal component based on the imaging data, and outputs the brightness to storage device 458. Storage device 458 overwrites and saves the brightness inside the outline of the normal component as the overlap determination data of the lead component in the first posture. That is, storage device 458 erases the overlap determination data of the lead component in the first posture stored previously together with the overlap determination storage date and time, and stores the brightness inside the outline of the normal component as the overlap determination data of the lead component in the first posture. In this case, storage device 458 stores the overlap determination storage date and time together with the overlap determination data. That is, storage device 458 updates the previously stored overlap determination data of the lead component in the first posture to the overlap determination data of the normal component in the first posture, and stores the update date and time as the overlap determination storage date and time together with the updated overlap determination data.

As described above, in a case where the pattern matching storage date and time and the overlap determination storage date and time are stored and the pattern matching storage date and time is later than the overlap determination storage date and time, the overlap determination data can be reliably updated together with the pattern matching data by updating the overlap determination data. As a result, in a case where the pattern matching data is updated to the data indicating the outline of the normal component, the overlap determination data can also be reliably updated to the data indicating the brightness inside the outline of the normal component.

It should be noted that lead component 410 is an example of a component. Storage device 458 is an example of a storage device. The pattern matching data is an example of master data. The overlap determination data is an example of an image determination process.

The present invention is not limited to the above-described examples, and can be implemented in various forms with various changes and improvements based on the knowledge of those skilled in the art. Specifically, for example, in the above embodiment, pattern matching data is used as master data, but various types of data may be used as long as the data relates to a component. Specifically, for example, data indicating a line, a surface, a color, a brightness, a gradation, and the like of a component and data indicating the type of component such as an identification code of the component may be used.

In the above embodiment, the pattern matching data and the overlap determination data are created in information processing device 460, but may be created in storage device 458. The pattern matching data and the overlap determination data may be created or stored in the same device, or the pattern matching data and the overlap determination data may be created or stored in different devices.

In the above embodiment, the pattern matching data and the overlap determination data are stored in the same storage device, but the pattern matching data and the overlap determination data may be stored in different devices. In such a case, for example, data may be transmitted from a storage device that stores the pattern matching data or the overlap determination data to a storage device that stores the overlap determination data or the pattern matching data, and the transmitted data may be stored.

In the above embodiment, each of the pattern matching data and the overlap determination data stored in storage device 458 is used, but a state of scattered components may be checked by using only one of the data.

In the above embodiment, a component in a posture in which an upper surface is horizontal among multiple scattered components is used as a pickup target component, but the present invention is not limited to the above posture, a component in a posture in which an upper surface is inclined may be recognized as a pickup target component by using either the pattern matching data or the overlap determination data, for example.

In the above embodiment, the bulk component supply device includes individual control device 452, but the present invention is not limited to the embodiment, and the present invention may be applied to a device in which various control devices controlling a device picking up multiple components, a so-called picking device, in a scattered state are connected to the picking device. Similarly, in the above embodiment, the bulk component supply device includes storage device 458, but the present invention is not limited to the embodiment, and the bulk component supply device may be connected to various control devices as described above, for example.

In the above embodiment, storage device 458 and information processing device 460 are different from each other, but storage device 458 and information processing device 460 may be provided in one device. That is, for example, information processing device 460 may include storage device 458.

In the above embodiment, the overlap determination data is updated as the pattern matching data is updated. In other words, a determination criterion for performing the overlap determination process is updated in accordance with update of the pattern matching data. On the other hand, as a method of updating a determination criterion for performing the overlap determination process in accordance with the update of the pattern matching data, an algorithm, a program, a processing method, or the like for performing the overlap determination process may be updated. In other words, the determination criterion for performing the overlap determination process may be updated in accordance with update of the pattern matching data.

In the above embodiment, in a case where the pattern matching data and the overlap determination data are updated, the updated pattern matching data and overlap determination data are overwritten and saved, but the updated pattern matching data and overlap determination data may be cumulatively stored together with the pattern matching data and the overlap determination data before the update. In other words, each time the pattern matching data and the overlap determination data are updated while maintaining the save of the pattern matching data and the overlap determination data before the update without erasing the pattern matching data and the overlap determination data before the update, the updated pattern matching data and the overlap determination data may be cumulatively saved.

In the above embodiment, the pattern matching data and the overlap determination data before update are erased, and the updated pattern matching data and overlap determination data are stored. In this case, after the pattern matching data and the overlap determination data before update are erased, the updated pattern matching data and overlap determination data may be stored. After the updated pattern matching data and overlap determination data are stored, the pattern matching data and the overlap determination data before update may be erased.

In the above embodiment, the date and time at which the pattern matching data and the overlap determination data are stored is stored in storage device 458, but it is sufficient if the date and time indicate a timing at which the pattern matching data and the overlap determination data are updated. Specifically, the date and time may be the date and time at which the pattern matching data and the overlap determination data are created, the date and time at which the OK button is operated on first creation screen 512 or the like in order to create the pattern matching data and the overlap determination data, the date and time at which new pattern matching data and overlap determination data are acquired, and the like.

In the above embodiment, the pattern matching data of lead component 410 is used as master data, and data regarding outlines of multiple lead components corresponding to a posture of lead component 410 is stored as the pattern matching data. That is, multiple pieces of master data are stored for each type of component. Multiple pieces of master data are not limited to the data regarding the outlines of multiple components corresponding to a posture of one type of component, and multiple pieces of master data may be stored for each of different types of components such as a color difference, a material, and characteristics although the components have the same shape.

In the above embodiment, all lead components scattered on the stage are imaged as a result of imaging performed once due to an angle of view of the camera that performs imaging, but for example, an imaging area may be divided into multiple areas and may be imaged multiple times. As a camera used in this case, a camera having a smaller angle of view than the stage may be used, or a camera having a larger angle of view may be used.

In the above embodiment, the present invention is applied to lead component 410, but the present invention can be applied to various components. Specifically, the present invention can be applied to, for example, components of a solar cell, components of a power module, and electronic circuit components having no leads.

### Reference Signs List

410: Lead component (component), 458: Storage device

## Claims

1. A storage device storing master data of one type of component and an image determination process for determining whether one component among multiple scattered components of one type overlaps another component based on an image obtained by imaging the one component, wherein in a case where the master data is updated, the image determination process is also updated.

2. The storage device according to claim 1, wherein a date and time at which the master data is updated is also stored.

3. The storage device according to claim 1 or 2, wherein multiple pieces of the master data are stored for each of the components of one type.

4. A method for updating an image determination process in a storage device in which master data corresponding to a posture when components of one type are scattered and an image determination process for determining whether one component among multiple scattered components of one type overlaps another component are stored, the method comprising:
a storage date and time comparison step of comparing a date and time at which the master data in the storage device is stored with a date and time at which the image determination process is stored;
an update step of updating the image determination process stored in the storage device by using the master data in a case where the date and time at which the master data is stored in the storage date and time comparison step is new; and
an overwriting step of erasing the image determination process stored in the storage device and causing the storage device to store the image determination process updated in the update step.
